# EUROPÄISCHE PATENTSCHRIFT

(11) **EP 0 360 328 B1**
(45) Veröffentlichungstag und Bekanntmachung des Hinweises auf die Patenterteilung: **14.07.1993**
(21) Anmeldenummer: 89202284.9
(22) Anmeldetag: 11.09.1989
(51) Int. Cl.: B23K 26/00

(54) **Vorrichtung zur Bearbeitung eines Werkstückes mit Laserlicht und Verwendung dieser Vorrichtung**
Device for treating a work piece with laser light, and use of this device
Dispositif pour le traitement d'une pièce à usiner avec lumière laser et utilisation de ce dispositif

(30) Priorität: 17.09.1988 DE 3831743
(43) Veröffentlichungstag der Anmeldung: 28.03.1990
(73) Patentinhaber: Philips Patentverwaltung GmbH, 22335 Hamburg (DE); Philips Electronics N.V., 5621 BA Eindhoven (NL)
(72) Erfinder: Dammann, Hans, Dr., D-2081 Tangstedt (DE); Rabe, Gert, D-2080 Pinneberg (DE); Patt, Paul J., Mount Kisko, N.Y. 10549 (US); Velzel, Christiaan Hendrik Frans, NL-5656 Eindhoven (NL); Schildbach, Klaus, Waalre (NL)
(74) Vertreter: Kupfermann, Fritz-Joachim, Dipl.-Ing.

(56) Entgegenhaltungen:
- AT-B- 288 120
- DE-A- 3 514 824
- US-A- 4 519 680
- PROCEEDINGS OF SPIE - THE INTERNATIONAL SOCIETY FOR OPTICAL ENGINEERING, Band 437, 25.-26. August 1983, International Conference on Computergenerated Holography H.DAMMANN "Synthetic digital-phase gratings - Design, features, applications" Seiten 72-78

## Beschreibung

Die Erfindung bezieht sich auf eine Vorrichtung zur Bearbeitung eines Werkstückes mit Laserlicht mit einem Laser, dessen Laserlichtstrahl durch eine Teileranordnung in mindestens zwei Teil-Laserlichtstrahlen weitgehend gleicher Intensität aufgeteilt wird, und mit einer Steueranordnung, welche die Lichtintensität des Lasers steuert und Werkstückauflage und den Laser relativ zueinander zur Positionierung des Werkstückes bewegt.

Eine solche Vorrichtung kann beispielsweise zum Löten oder Schweißen von elektronischen Bauelementen auf Schaltungsplatinen mit Hilfe eines Laserlichtstrahls dienen. Das Werkstück stellt hierbei die eine Bauelemente mit der Schaltungsplatine dar.

Die eingangs genannte Vorrichtung ist aus der DE-A-29 34 407 bekannt. Hierbei wird der aus einem Laser austretende Laserlichtstrahl durch eine Doppelschlitzblende (Teileranordnung) in zwei Teil-Laserlichtstrahlen zerlegt, die mittels einer optischen Ablenkanordnung auf die Anschlußelemente eines elektronischen Bauelementes gelenkt werden. Dabei kann das Bauelement durch eine Werkstückauflage positioniert und zusätzlich die Teil-Laserlichtstrahlen durch Einstellung der in der optischen Ablenkanordnung verwendeten Spiegel verändert werden. Es hat sich in der Praxis gezeigt, daß es fast unmöglich ist, oder einen großen technischen Aufwand erfordert eine auch nur annähernd genaue Gleichverteilung der Energie auf die verschiedenen Teil-Laserlichtstrahlen zu erreichen. Die Teil-Laserlichtstrahlen müssen jedoch eine weitgehend gleiche Intensität besitzen, da sonst unter dem einen Teil-Laserlichtstrahl die Bauelemente oder die Schaltungsplatine verbrennen, während die Intensität des anderen Teil-Laserlichtstrahls unter Umständen nicht ausreicht, um eine befriedigende Lötverbindung zu erreichen. Außerdem geht durch die Verwendung einer Doppelschlitzblende Energie des Laserlichtstrahls verloren.

Des weiteren ist eine Vorrichtung zum gleichzeitigen Auflöten von zwei Anschlußelementen eines elektronischen Bauelementes auf eine Schaltungsplatine aus der DE-C-35 39 933 bekannt. Hierbei werden von einem Laser zwei Teil-Laserlichtstrahlen gleicher Intensität erzeugt, die über eine optische Ablenkvorrichtung auf die Anschlußelemente eines Bauelementes gelenkt werden. Die Erzeugung von Teil-Laserlichtstrahlen gleicher Intensität ist aber sehr aufwendig.

Bei den oben genannten bekannten Vorrichtungen werden die beiden Teil-Laserlichtstrahlen durch eine optische Ablenkanordnung, die bewegbare Spiegel enthält, auf die Anschlußelemente gelenkt. Vor dem Lötvorgang werden daher die Spiegel ausgerichtet. Mit dieser Vorrichtung lassen sich nicht gleichzeitig Bauelemente auf einer Schaltungsplatine anlöten bzw. anschweißen, wenn mehr als zwei Anschlußelemente vorhanden sind. Die bekannten Vorrichtungen sind außerdem aufwendig aufgebaut, und vor der Bearbeitung des Werkstückes sind aufwendige Positionierungsvorgänge der Spiegel durchzuführen.

Es liegt der Erfindung daher die Aufgabe zugrunde, eine Vorrichtung zur Bearbeitung eines Werkstückes mitLaserlicht zu schaffen, bei der eine Bearbeitung eines Werkstückes auf einfache Art erfolgt.

Diese Aufgabe wird bei einer Vorrichtung der eingangs genannten Art dadurch gelöst, daß die Teileranordnung wenigstens ein binäres Phasen-Beugungsgitter enthält, durch die der vom Laser kommende Laserlichtstrahl in mehrere Teil-Laserlichtstrahlen aufgeteilt wird zur Erzeugung eines Projektionsmusters auf dem Werkstück.

Bei der erfindungsgemäßen Vorrichtung wird durch ein binäres Phasen-Beugungsgitter eine Anzahl von Teil-Laserlichtstrahlen weitgehend gleicher Intensität erzeugt. Solche binären Phasen-Beugungsgitter sind z.B. aus der EP-A-0 00 28 73 oder aus der Veröffentlichung "Synthetic digital-phase gratings - Design, features, applications" von H. Dammann, Proceedings of the International Society for Optical Engineering, Volume 437, International Conference on Computer-generated Holography, 25.-26. August 1983, S. 72 -78, bekannt. Binäre Phasen-Beugungsgitter können je nach Ausführung eine unterschiedliche Anzahl von Teil-Laserlichtstrahlen erzeugen, die senkrecht auf eine Wand projeziert ein Projektionsmuster ergeben. Hierbei tritt ein geringer Verlust von Energie des Laserlichtes auf, d.h. die Energie des Laserlichtes wird annähernd gleichförmig auf die Teil-Laserlichtstrahlen verteilt. Die Endpunkte der Teil-Laserlichtstrahlen in der Projektionsebene weisen in einer Richtung einer Wandebene gleiche Abstände auf. Mit Hilfe eines binären Phasen-Beugungsgitter können also beispielsweise alle Anschlußelemente einer integrierten Schaltung, die in regelmäßigem Abstand angeordnet sind, in einem Arbeitsschritt auf eine Schaltungsplatine gelötet werden. Ein binäres Phasen-Beugungsgitter erzeugt dabei Teil-Laserlichtstrahlen, deren Projektionsmuster dem Muster der Anschlußelemente der integrierten Schaltung entspricht.

Bei der Bearbeitung eines Werkstückes sind in der Regel unterschiedliche Arbeitsschritte erforderlich. So treten z.B. bei der Lötung von Bauelementen auf einer Schaltungsplatine unterschiedliche Anforderungen auf. So kann ein erstes binäres Phasen-Beugungsgitter zwei Teil-Laserlichtstrahlen zur Lötung der beiden Anschlußelemente eines Widerstandes und ein zweites binäres Phasen-Beugungsgitter drei Teil-Laserlichtstrahlen zur Lötung der drei Anschlußelemente eines Transistors erzeugen. Vor einem Arbeitsschritt wird daher von der Steueranordnung ein binäres Phasen-Beugungsgitter in den Strahlengang des Laserlichtstrahles gebracht, welches das erforderliche Projektionsmuster bildet. Hierdurch kann eine Ausrichtung mit Spiegeln in der optischen Ablenkanordnung entfallen.

Die Herstellung der binären Phasen-Beugungsgitter ist aus der schon genannten Veröffentlichung "Synthetic digital-Phase gratings - Design, features, applications" von H. Dammann, Proceedings of the International Society for Optical Engineering, Volume 437, International Conference on Computer-generated Holography, 25.-26. August 1983, S. 72 -78, bekannt. Ein solches binäres Phasen-Beugungsgitter erzeugt Teil-Laserlichtstrahlen, deren Projektionsmuster eine Linie mit Punkten in gleichen Abständen darstellt. Diese Lichtpunkte weisen im wesentlichen alle dieselbe Intensität auf.

Es sei noch erwähnt, daß es aus der DE-A-29 16 184 bekannt ist, binäre Phasen-Beugungsgitter in einer Lichtleiteranordnung zu verwenden. Hierbei wird der aus einem Lichtleiter austretende Lichtstrahl mittels eines binären Phasen-Beugungsgitters in mehrere Teil-Laserlichtstrahlen geteilt, die in weitere Lichtleiter eingestrahlt werden.

Um eine einfache Möglichkeit zur Einbringung eines binären Phasen-Beugungsgitters in den Laserlichtstrahlengang zu schaffen, ist vorgesehen, daß die Steueranordnung eine erste, drehbar in der Teileranordnung angeordnete Gitterscheibe steuert, auf der wenigstens zwei binäre Phasen-Beugungsgitter angebracht sind.

Bei der Verwendung von binären Phasen-Beugungsgittern können nur Projektionsmuster mit Punkten in einer Linie erzeugt werden. Um ein Projektionsmuster mit mehreren Parallelen Linien zu erzeugen, ist vorgesehen, daß die Steueranordnung eine zweite, drehbar in der Teileranordnung angeordnete Gitterscheibe steuert, auf der wenigstens ein weiteres binäres Phasen-Beugungsgitter zum Einbringen in den Strahlengang der Teil-Laserlichtstrahlen angebracht ist. Wenn die beiden binären Phasen-Beugungsgitter zueinander um 90° verschoben sind, ergibt sich ein rechteckförmiges Projektionsmuster. Wird ein anderer Winkel als 90° gewählt, ergibt sich ein rautenförmiges Muster.

Die von einem binären Phasen-Beugungsgitter erzeugten Teil-Laserlichtstrahlen werden gemäß ihrer unterschiedlichen Beugung in Beugungsordnungen eingeteilt. Der nicht abgelenkte aus dem binären Phasen-Beugungsgitter austretende Teil-Laserlichtstrahl wird als Teil-Laserlichtstrahl nullter Ordnung bezeichnet. Die daneben liegenden Teil-Laserlichtstrahlen werden Teil-Laserlichtstrahl höherer Positiver oder negativer Ordnung genannt. So stellen die Teil-Laserlichtstrahlen direkt neben dem Teil-Laserlichtstrahl nullter Ordnung Teil-Laserlichtstrahlen erster Ordnung dar.

Die binären Phasen-Beugungsgitter erzeugen in der Praxis nicht nur die gewünschten Teil-Laserlichtstrahlen sondern auch Teil-Laserlichtstrahlen höherer Ordnung mit weitaus geringerer Intensität. Um diese Teil-Laserlichtstrahlen höherer Ordnung zu unterdrücken, ist vorgesehen, daß eine Blende in den Strahlengang der Teil-Laserlichtstrahlen einbringbar ist. Um eine einfache Möglichkeit zur Einbringung einer Blende zu schaffen, ist vorgesehen, daß die Steueranordnung eine drehbar angeordnete Blendenscheibe steuert, auf der wenigstens zwei unterschiedliche Blenden zur Unterdrückung von Teil-Laserlichtstrahlen höherer Ordnung angebracht sind.

Um eine Bearbeitung an Kanten eines Werkstückes zu ermöglichen, ist eine optische Ablenkanordnung vorgesehen, die eine Spiegelanordnung enthält, welche die Teil-Laserlichtstrahlen schräg zur Werkstückauflageebene auf das Werkstück lenkt. Hiermit wird insbesondere das Anlöten von SMD-Bauelementen, deren Anschlußelemente nicht über die Grundfläche des Bauelementes vorstehen, auf eine Schaltungsplatine ermöglicht. Teil-Laserlichtstrahlen in senkrechter Ausrichtung zur Werkstückauflageebene können nämlich die Anschlußelemente eines SMD-Bauelementes nicht erreichen.

Verwendet werden kann die erfindungsgemäße Vorrichtung zum Löten oder Schweißen der Anschlußelemente von elektronischen Bauelementen durch Laserlicht auf einer Schaltungsplatine. Hierbei ist vorgesehen, daß in einem Arbeitsschritt alle Anschlußelemente eines Bauelementes gleichzeitig angelötet oder angeschweißt werden,
daß die Steueranordnung vor Beginn eines Arbeitsschrittes zur Erzeugung eines Projektionsmusters, das dem Muster der Löt- bzw. Schweißstellen der Anschlußelemente entspricht, die erforderlichen binären Phasen-Beugungsgitter bzw. eine Blende durch Drehung der ersten und/oder zweiten Gitterscheibe bzw. der Blendenscheibe in den Strahlengang des Laserlichtstrahls bzw. der Teil-Laserlichtstrahlen bringt und
daß der Laser nur während eines Arbeitsschrittes die erforderliche Intensität des Laserlichtstrahls zum Löten bzw. Schweißen aufweist.

Das Auflöten von elektronischen Bauelementen auf Schaltungsplatinen mit Hilfe eines Laserlichtstrahls hat den Vorteil, daß durch den scharf fokussierten Laserlichtstrahl nur die Lötstelle erwärmt wird, so daß eine globale Erwärmung der Schaltungsplatine und/oder der einzelnen elektronischen Bauelemente und damit eine potentielle Gefährung derselben durch Überhitzung vermieden werden kann.

Als Arbeitsschritt wird bei dieser Verwendung der Löt-oder Schweißvorgang angesehen. Vor dem eigentlichen Arbeitsschritt werden in der Vorrichtung von der Steueranordnung die erforderlichen binären Phasen-Beugungsgitter und eine Blende in den Strahlengang der Laserlichtstrahlen gebracht und die Schaltungsplatine mittels der Werkstückauflage positioniert. Anschließend wird die Intensität des Laserlichtstrahls erhöht, und der Löt- bzw. Schweißvorgang beginnt. Die Intensität der einzelnen Teil-Laserlichtstrahlen ist dabei gleich, d.h. an jeder Lötstelle wird mit einer im wesentlichen gleich großen Temperatur gelötet oder geschweißt. Durch die Verminderung der Intensität zwischen den Arbeitsvorgängen wird der Energieverbrauch reduziert und eine Zerstörung von Bauelementen oder Schaltungsplatine verhindert. Es ist auch möglich, den Laser zwischen den Arbeitsvorgängen abzuschalten.

Die erfindungsgemäße Vorrichtung kann auch zum Erzeugen von Folienbahnen für Folienkondensatoren verwendet werden. Hierbei ist vorgesehen, daß in einem ersten Arbeitsschritt von einer mit Metall beschichteten Folie erste Linien mit verdampftem Metall gebildet werden und in einem zweiten Arbeitsschritt die Folie längs an zweiten Linien zur Erzeugung von Folienbahnen getrennt wird, die annähernd so breit sind wie die halbe Breite zwischen zwei ersten Linien, in dem die Werkstückauflage in jedem Arbeitsschritt die Folie senkrecht zur Einfallsrichtung der Teil-Laserlichtstrahlen bewegt,
daß die Steueranordnung vor Beginn eines Arbeitsschrittes zur Erzeugung eines Projektionsmusters, das dem Muster der Verdampfungs- bzw. Schneidstellen entspricht, die erforderlichen binären Phasen-Beugungsgitter bzw. eine Blende durch Drehung der ersten und/oder zweiten Gitterscheibe bzw. der Blendenscheibe in den Strahlengang des Laserlichtstrahls bzw. der Teil-Laserlichtstrahlen bringt und
daß der Laser nur während eines Arbeitsschrittes die erforderliche Intensität des Laserlichtstrahls zum Verdampfen bzw. Schneiden aufweist.

Bei dieser Verwendung weist der Laserlichtstrahl drei unterschiedliche Intensitäten auf. Zwischen den Arbeitsschritten ist die Intensität des Laserlichtstrahls sehr gering eingestellt, so daß die Folie nicht beschädigt wird. Während des ersten Arbeitsschrittes muß die Intensität des Laserlichtstrahls so groß gewählt werden, daß nur Metall, z.B. Aluminium, von der Folie wegdampfen kann. Beim zweiten Arbeitsschritt ist die Intensität des Laserlichtstrahls am größten. Hierbei muß soviel Energie geliefert werden, daß die Folie zerschnitten werden kann.

Ausführungsbeispiele der Erfindung werden nachstehend anhand der Zeichnungen näher erläutert. Es zeigen:
Fig. 1 eine vereinfacht dargestellte Anordnung zur Erzeugung von Teil-Laserlichtstrahlen mittels eines binären Phasen-Beugungsgitter aus einem Laserlichtstrahl,
Fig. 2 einen Querschnitt durch ein lineares binäres Phasen-Beugungsgitter,
Fig. 3 die Anordnung nach Fig. 1 mit einem weiteren binären Phasen-Beugungsgitter,
Fig. 4 die Anordnung nach Fig. 1 mit einer Blende,
Fig. 5 eine schematisch dargestellte Vorrichtung zum Löten von Anschlußelementen eines Bauelementes auf einer Schaltungsplatine und
Fig. 6 eine schematisch dargestellte Vorrichtung zum Erzeugen von Folienbahnen für Folienkondensatoren.

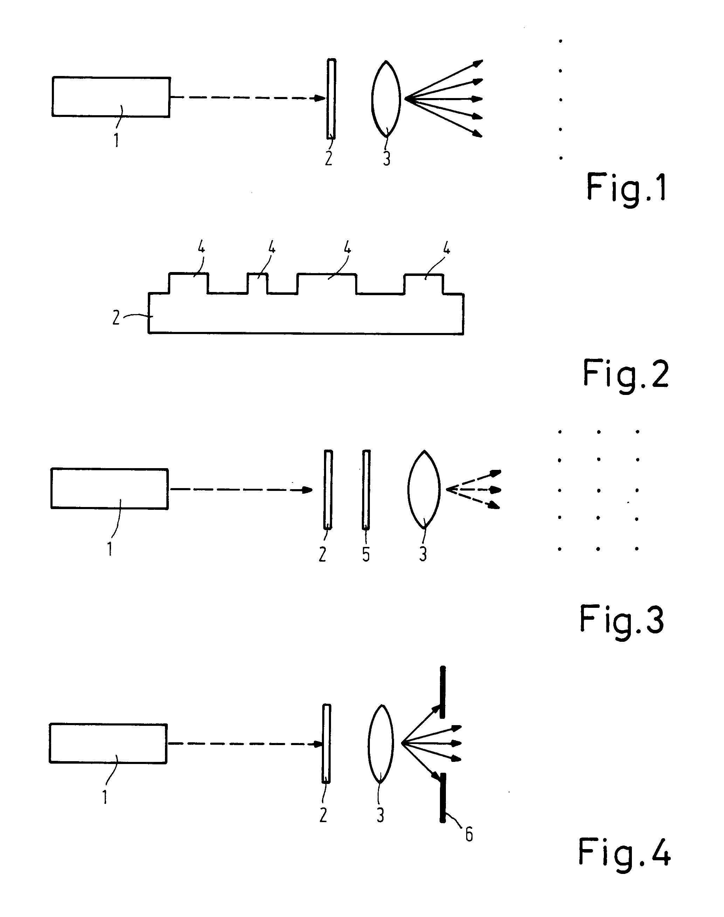

Die in Fig. 1 dargestellte Anordnung zur Erzeugung von Teil-Laserlichtstrahlen aus einem Laserlichtstrahl, welche Bestandteil einer Vorrichtung zur Bearbeitung eines Werkstückes mit Laserlicht ist, enthält einen Laser 1, der einen Laserlichtstrahl auf ein binäres Phasen-Beugungsgitter 2 strahlt. Das binäre Phasen-Beugungsgitter 2 erzeugt aus dem Laserlichtstrahl durch Beugung Teil-Laserlichtstrahlen, die mittels einer Linse 3 fokussiert werden.

Ein solches binäres Phasen-Beugungsgitter 2 ist in der Fig. 2 im Querschnitt dargestellt. Es ist ein optisches Element mit mehreren parallelen, im Querschnitt rechteckförmigen Streifen. Die Herstellung eines solchen binären Phasen-Beugungsgitters 2 ist aus der Veröffentlichung "Synthetic digital-phase gratings - Design, features, applications" von H. Dammann, Proceedings of the International Society for Optical Engineering, Volume 437, International Conference on Computer-generated Holography, 25.-26. August 1983, S. 72 -78, bekannt. Dieses binäre Phasen-Beugungsgitter 2 mit seiner regelmäßigen Struktur erzeugt aus dem Laserlichtstrahl eine bestimmte - bei einfachen Strukturen - ungerade Zahl von Teil-Laserlichtstrahlen. Diese Teil-Laserlichtstrahlen werden gemäß ihrer unterschiedlichen Beugung in Beugungsordnungen eingeteilt. Der ungebeugte Teil-Laserlichtstrahl wird als Teil-Laserlichtstrahl nullter Ordnung bezeichnet. Die direkt daneben liegenden Teil-Laserlichtstrahlen als Teil-Laserlichtstrahlen negativer und positiver erster Ordnung benannt. Als Beispiel ist in der Fig. 1 ein binäres Phasen-Beugungsgitter zweiter Ordnung dargestellt, das fünf Teil-Laserlichtstrahlen erzeugt und dessen Projektionsmuster rechts neben der Anordnung der Fig. 1 dargestellt ist und eine Linie von fünf Lichtpunkten mit gleichem Abstand darstellt.

Mittels eines weiteren binären Phasen-Beugungsgitters 5, das vor oder hinter dem binären Phasen-Beugungsgitter 2 angeordnet ist, kann ein rechteckförmiges oder rautenförmiges Projektionsmuster erzeugt werden. Wie aus der Fig. 3 ersichtlich ist, wird vom Laser 1 ein Laserlichtstrahl auf das binäre Phasen-Beugungsgitter 2 gegeben, das Teil-Laserlichtstrahlen erzeugt, die über das weitere binäre Phasen-Beugungsgitter 5 gegeben und mittels der Linse 3 fokussiert werden. In der Zeichnung rechts neben der Anordnung ist ein rechteckförmiges Projektionsmuster mit fünfzehn Lichtpunkten dargestellt. Das binäre Phasen-Beugungsgitter 2 erzeugt in diesem Beispiel aus einem Laser-Lichtstrahl fünf Teil-Laserlichtstrahlen und das binäre Phasen-Beugungsgitter 5 aus einem Laserlichtstrahl drei Teil-Laserlichtstrahlen. Werden die beiden binären Phasen-Beugungsgitter so zueinander gestellt, daß sie um 90° verschoben sind, d.h., daß die Streifen der binären Phasen-Beugungsgitter einen 90°-Versatz aufweisen, wird ein rechteckförmiges Projektionsmuster gebildet. Die Anzahl der Lichtpunkte des Projektionsmusters ist gleich dem Produkt der von den beiden binären Phasen-Beugungsgittern 2 und 5 aus einem Laserlichtstrahl erzeugten Teil-Laserlichtstrahlen. Es läßt sich auch ein rautenförmiges Projektionsmuster bilden, wenn der Versatz zwischen den beiden binären Phasen-Beugungsgittern 2 und 4 zwischen 0° und 90° liegt.

Die binären Phasen-Beugungsgitter erzeugen nicht nur die gewünschten Teil-Laserlichtstrahlen, sondern auch Teil-Laserlichtstrahlen höherer Ordnung, die unerwünscht sind. Zur Unterdrückung solcher unerwünschter Teil-Laserlichtstrahlen höherer Ordnung kann eine Blende 6 verwendet werden, die hinter der Linse 3 angeordnet ist, wie das Fig. 4 darstellt. Die Blende 6 sollte dabei nicht im Brennpunkt der Teil-Laserlichtstrahlen höherer Ordnung angeordnet sein, da diese möglicherweise dann die Blende 6 zerstören könnten.

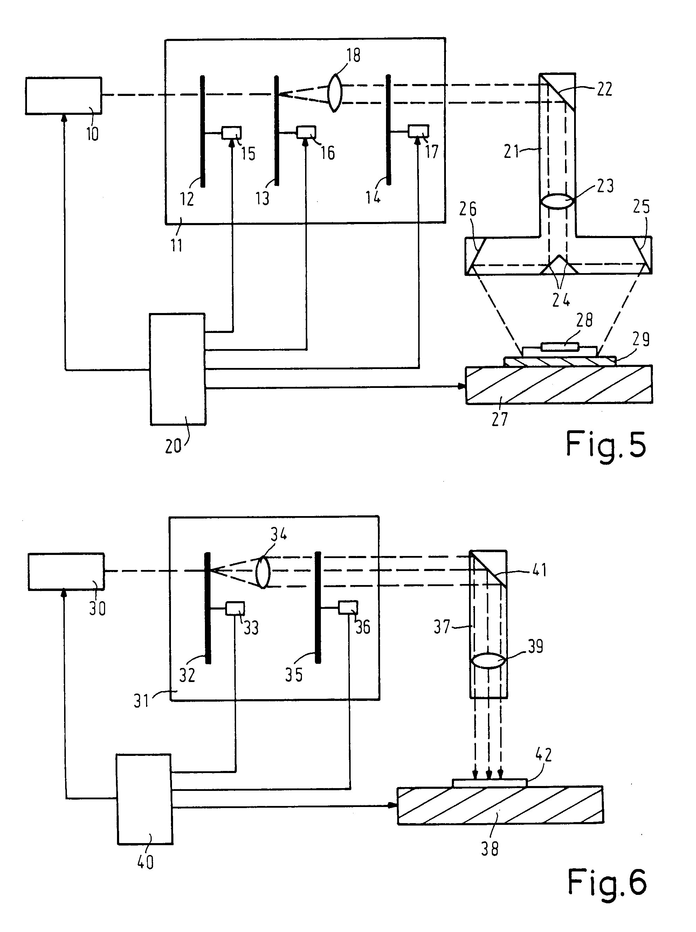

Im folgenden werden zwei Ausführungsbeispiele für eine Vorrichtung zur Bearbeitung eines Werkstücks mit Laserlicht erläutert. Ein erstes Ausführungsbeispiel ist in Fig. 5 dargestellt und zeigt eine Vorrichtung zum Löten der Anschlußelemente von elektronischen Bauelementen auf einer Schaltungsplatinen. Diese Vorrichtung enthält einen Laser 10, der einen Laserlichtstrahl auf eine Teileranordnung 11 strahlt, die zwei Gitterscheiben 12 und 13 mit darauf angeordneten binären Phasen-Beugungsgittern, eine Linse 18 und eine Blendenscheibe 14 mit darauf angeordneten Blenden enthält. Die drehbar angeordneten Scheiben 12, 13 und 14 werden mittels Schrittmotoren 15, 16 und 17 bewegt, die eine Steueranordnung 20 steuert. Außerdem steuert die Steueranordnung 20 den Laser 10. Die auf den Gitterscheiben 12 und 13 angeordneten binären Phasen-Beugungsgitter erzeugen Teil-Laserlichtstrahlen, wovon die Teil-Laserlichtstrahlen höherer Ordnung von einer Blende, die auf der Blendenscheibe 14 angeordnet ist, unterdrückt werden.

Die durch die Blende auf der Blendenscheibe 14 hindurchtretenden Teil-Laserlichtstrahlen werden über eine optische Ablenkanordnung 21, auf die Anschlußelemente eines Bauelementes 28, das mit einer Schaltungsplatine 29 verlötet werden soll, abgelenkt. Die Ablenkanordnung enthält einen ersten Spiegel oder Prisma 22, das die Teil-Lichtstrahlen um 90° ablenkt und über eine Linsenanordnung 23 zu zwei gekreuzt stehenden Spiegeln oder Prismen 24 führt, die die Teil-Laserlichtstrahlen trennen. Die Linsenanordnung 23 kann eine variable Brennweite enthalten (Zoom-Objektiv). Dadurch kann das Projektionsmuster verkleinert bzw. vergrößert werden. Die Spiegel 24 lenken die Teil-Laserlichtstrahlen die von dem Spiegel 22 kommen, wiederum um 90° um, so daß der jeweilige entgegengesetzte Strahlverlauf der Teil-Laserlichtstrahlen ungefähr parallel zur Schaltungsplatine 29 verläuft. Diese von den Spiegeln 24 ausgehenden Teil-Laserlichtstrahlen werden von jeweils zwei weitere Spiegeln oder Prismen 25 und 26 so umgelenkt, daß die Teil-Laserlichtstrahlen schräg zur Fläche der Schaltungsplatine 29 auf die Anschlußelemente des Bauelementes 28 auftreffen.

Die Schaltungsplatine 29 wird von einer Werkstückauflage 27 gehaltert. Die Werkstückauflage 27 wird von der Steueranordnung 20 gesteuert und dient zur Positionierung der Schaltungsplatine 29.

Im folgenden wird erläutert, wie mit Hilfe dieser Vorrichtung verschiedene elektronische Bauelemente 28 auf die Schaltungsplatine 29 angelötet werden. Vor dem eigentlichen Lötvorgang (Arbeitsschritt) werden in der Teileranordnung 11 die Gitterscheiben 12 und 13 und die Blendenscheibe 14 bewegt und die Werkstückauflage 27 positioniert. Während dieser Zeit ist der Laser 10 abgeschaltet. In der Teileranordnung 11 werden also die Gitterscheiben 12 und 13 und die Blendenscheibe 14 so gedreht, daß die erforderlichen binären Phasen-Beugungsgitter bzw. die erforderliche Blende in dem Strahlengang des Laserlichtstrahls bzw. der Teil-Laserlichtstrahlen liegen. Die Schaltungsplatine 29 mit dem anzulötenden Bauelement 28 wird von der Werkstückauflage 27 so positioniert, daß die von der otpischen Ablenkanordnung 21 abzulenkenden Teil-Laserlichtstrahlen auf die Anschlußelemente des Bauelementes 28 auftreffen. Das Projektionsmuster der Teil-Laserlichtstrahlen entspricht dabei dem Muster der Lötstellen bzw. der Anschlußelemente des Bauelementes 28.

Ist beispielsweise vorgesehen, eine integrierte Schaltung mit 2 x 8 Anschlußelementen zu löten, so wird in der Teileranordnung 11 vor dem eigentlichen Lötvorgang ein binäres Phasen-Beugungsgitter durch Drehen der Gitterscheibe 12 von dem Schrittmotor 15 in den Strahlengang gebracht, das aus einem Laserlichtstrahl acht Teil-Laserlichtstrahlen erzeugt und von dem Schrittmotor 16 ein binäres Phasen-Beugungsgitter durch Drehen der Gitterscheibe 13 hineingebracht, das aus einem Laserlichtstrahl zwei Teil-Laserlichtstrahlen erzeugt. Nach dem Anschalten des Lasers 10 werden dann mittels der Teil-Laserlichtstrahlen die Anschlußelemente der integrierten Schaltung auf der Schaltungsplatine 29 angelötet. Soll dann im nächsten Arbeitsschritt ein Bauelement mit zwei Anschlußelementen auf der Schaltungsplatine 29 angelötet werden, wird von der Steueranordnung 20 der Schrittmotor 15 so gesteuert, daß ein binäres Phasen-Beugungsgitter in den Strahlengang gebracht wird, das zwei Teil-Laserlichtstrahlen erzeugt. Die Gitterscheibe 13 muß in diesem Fall ein Loch aufweisen, damit keine weitere Vervielfachung der von der Gitterscheibe 12 ausgehenden Teil-Laserlichtstrahlen vorgenommen wird.

In Fig. 6 ist ein zweites Ausführungsbeispiel dargestellt. Diese Vorrichtung dient zum Erzeugen von Folienbahnen für Folienkondensatoren. Ein von einem Laser 30 erzeugter Laserlichtstrahl wird auf eine Teileranordnung 31 gestrahlt. Diese Teileranordnung 31 enthält eine Gitterscheibe 32 mit zwei binären Phasen-Beugungsgittern, die mittels eines Schrittmotors 33 in den Strahlengang des Laserlichtstrahls einbringbar sind. Die von einem binären Phasen-Beugungsgitter der Gitterscheibe 32 erzeugten Teil-Laserlichtstrahlen werden von einer Linse 34 fokussiert. Hinter der Linse 34 ist eine Blendenscheibe 35 angeordnet, die zwei weitere Blenden zur Unterdrückung von Teil-Laserlichtstrahlen höherer Ordnung aufweist. Diese Blendenscheibe 35 wird von einem Schrittmotor 36 bewegt. Die von der Teileranordnung 31 abgegebenen Teil-Laserlichtstrahlen werden über eine optische Ablenkanordnung 37 in Richtung einer Werkstückauflage 38 abgelenkt. Die optische Ablenkanordnung 37 enthält einen Spiegel oder ein Prisma 41, das die Teil-Laserlichtstrahlen um 90° zu einer Linsenanordnung 39 ablenkt, über welche die vom Spiegel 41 kommenden Teil-Laserlichtstrahlen auf eine Folie 42 auftreffen.

Der Laser 30, die Schrittmotoren 33 und 36 und die Werkstückauflage 38 werden von einer Steueranordnung 40 gesteuert. Auf der Werkstückauflage 38 ist die Folie 42, die z.B. aus Polyester mit aufgedampftem Aluminium besteht, angeordnet. Mit Hilfe der Vorrichtung werden aus der Folie 42 Folienbahnen für Folienkondensatoren hergestellt. In einem ersten Arbeitsschritt werden Teil-Laserlichtstrahlen auf die Folie 42 gestrahlt, die ein Projektionsmuster erzeugen, das einer Linie von Lichtpunkten entspricht. Diese Lichtpunkte weisen die gleichen Abstände untereinander auf. Unter diesen Teil-Laserlichtstrahlen wird die Werkstückauflage 38 senkrecht zur Einfallsrichtung der Teil-Laserlichtstrahlen bewegt, so daß bei genügend hoher Einstellung der Intensität des Laserlichtstrahls erste Linien von verdampftem Aluminium auf der Folie 42 entstehen. Im nächsten Arbeitsschritt wird dann ein solches binäres Phasen-Beugungsgitter mittels des Schrittmotors 33 in den Strahlengang des Laserlichtstrahls gebracht, das ein Projektionsmuster bildet, welches Lichtpunkte aufweist, deren Abstände annähernd die halbe Breite zwischen zwei ersten Linien mit verdampftem Metall aufweisen. Nach Anschaltung des Lasers wird dann die Folie 42 unter den Teil-Laserlichtstrahlen hinwegbewegt. Hierdurch entstehen zweite Linien, die eine Trennlinie zwischen den Folienbahnen darstellen. Die Intensität des Lasers 10 ist dabei so eingestellt, daß die Folie an den Auftreffstellen der Teil-Laserlichtstrahlen getrennt wird. Die Breite einer von der Folie 42 abgetrennten Folienbahnen entspricht also der halben Breite zwischen ersten Linien mit verdampftem Metall. Die Folienbahnen werden dann in weiteren Arbeitsschritten an einer anderen Vorrichtung gefaltet und zu einem Folienkondensator gedreht und mit Anschlüssen versehen.

## Patentansprüche

1. Vorrichtung zur Bearbeitung eines werkstückes mit Laserlicht
mit einem Laser (10, 30), dessen Laserlichtstrahl durch eine Teileranordnung (11, 31) in mindestens zwei Teil-Laserlichtstrahlen weitgehend gleicher Intensität aufgeteilt wird, und
mit einer Steueranordnung (20, 40), welche die Lichtintensität des Lasers (10, 30) steuert und eine Werkstückauflage (27, 38) und den Laser (10, 30) relativ zueinander zur Positionierung des Werkstückes (23, 42) bewegt,
dadurch gekennzeichnet, daß die Teileranordnung (11, 31) wenigstens ein binäres Phasen-Beugungsgitter (12, 32) enthält, durch die der vom Laser (10, 30) kommende Laserlichtstrahl in mehrere Teil-Laserlichtstrahlen aufgeteilt wird zur Erzeugung eines Projektionsmusters auf dem Werkstück (23, 42).

2. Vorrichtung nach Anspruch 1,
dadurch gekennzeichnet, daß die Steueranordnung (20, 40) eine erste, drehbar in der Teileranordnung (11, 31) angeordnete Gitterscheibe (12, 32) steuert, auf der wenigstens zwei binäre Phasen-Beugungsgitter angebracht sind.

3. Vorrichtung nach Anspruch 2,
dadurch gekennzeichnet, daß die Steueranordnung (20, 40) eine zweite, drehbar in der Teileranordnung (11) angeordnete Gitterscheibe (13) steuert, auf der wenigstens ein weiteres binäres Phasen-Beugungsgitter zum Einbringen in den Strahlengang der Teil-Laserlichtstrahlen angebracht ist.

4. Vorrichtung nach einem der vorhergehenden Ansprüche,
dadurch gekennzeichnet, daß eine Blende (35) in den Strahlengang der Teil-Laserlichtstrahlen zur Unterdrückung von Teil-Laserlichtstrahlen höherer Ordnung einbringbar ist.

5. Vorrichtung nach Anspruch 4,
dadurch gekennzeichnet, daß die Steueranordnung (20, 40) eine drehbar angeordnete Blendenscheibe (35) steuert, auf der wenigstens zwei unterschiedliche Blenden zur Unterdrückung von Teil-Laserlichtstrahlen höherer Ordnung angebracht sind.

6. Vorrichtung nach einem der vorhergehenden Ansprüche,
dadurch gekennzeichnet, daß eine optische Ablenkanordnung (21) vorgesehen ist, die eine Spiegelanordnung (24, 25, 26) enthält, welche die Teil-Laserlichtstrahlen schräg zur Werkstückauflageebene auf das Werkstück (29) lenkt.

7. Verwendung einer Vorrichtung nach den Ansprüchen 1 bis 6 zum Löten oder Schweißen der Anschlußelemente von elektronischen Bauelementen (28) durch Laserlicht auf einer Schaltungsplatine (29),
wobei in einem Arbeitsschritt alle Anschlußelemente eines Bauelementes (28) gleichzeitig angelötet oder angeschweißt werden,
wobei die Steueranordnung (20) vor Beginn eines Arbeitsschrittes zur Erzeugung eines Projektionsmusters, das dem Muster der Löt- bzw. Schweißstellen der Anschlußelemente entspricht, die erforderlichen binären Phasen-Beugungsgitter bzw. eine Blende durch Drehung der ersten und/oder zweiten Gitterscheibe (12, 13) bzw. der Blendenscheibe (14) in den Strahlengang des Laserlichtstrahls bzw. der Teil-Laserlichtstrahlen bringt und wobei der Laser (10) nur während eines Arbeitsschrittes die erforderliche Intensität des Laserlichtstrahls zum Löten bzw. Schweißen aufweist.

8. Verwendung einer Vorrichtung nach den Ansprüchen 1 bis 5 zum Erzeugen von Folienbahnen für Folienkondensatoren,
wobei in einem ersten Arbeitsschritt von einer mit Metall beschichteten Folie (42) erste Linien mit verdampftem Metall gebildet werden und in einem zweiten Arbeitsschritt die Folie (42) längs an zweiten Linien zur Erzeugung von Folienbahnen getrennt wird, die annähernd so breit sind wie die halbe Breite zwischen zwei ersten Linien, indem die Werkstückauflage (38) in jedem Arbeitsschritt die Folie (42) senkrecht zur Einfallsrichtung der Teil-Laserlichtstrahlen bewegt,
wobei die Steueranordnung (40) vor Beginn eines Arbeitsschrittes zur Erzeugung eines Projektonsmusters, das dem Muster der Verdampfungs- bzw. Schneidstellen entspricht, die erforderlichen binären Phasen-Beugungsgitter bzw. eine Blende durch Drehung der ersten und/oder zweiten Gitterscheibe (32) bzw. der Blendenscheibe (35) in den Strahlengang des Laserlichtstrahls bzw. der Teil-Laserlichtstrahlen bringt und
wobei der Laser (30) nur während eines Arbeitsschrittes die erforderliche Intensität des Laserlichtstrahls zum Verdampfen bzw. Schneiden aufweist.

## Claims

1. An arrangement for working a workpiece using laser light, comprising a laser (10, 30) whose laser light beam is split by a splitter (11, 31) into at least two sub-laser light beams of a largely identical intensity and
a control device (20, 40) controlling the light intensity of the laser (10, 30) and moving a workpiece support (27, 38) and the laser (10, 30) with respect to each other so as to position the workpiece (23, 42),
characterized in that the splitter (11, 31) includes at least one digital phase grating (12, 32) which divides the laser light beam coming from the laser (10, 30) into a plurality of sub-laser light beams to produce a projection pattern on the workpiece (23, 42).

2. An arrangement as claimed in Claim 1, characterized in that the control device (20, 40) controls a first grating disc (12, 32) which is rotatably arranged in the splitter (11, 31), onto which at least two digital phase gratings are provided.

3. An arrangement as claimed in Claim 2, characterized in that the control device (20, 40) controls a second grating disc (13) which is rotatably arranged in the splitter (11), onto which at least a further digital phase grating for insertion into the beam path of the sub-laser light beams is provided.

4. An arrangement as claimed in any one of the preceding Claims, characterized in that a diaphragm (35) can be arranged in the beam path of the sub-laser light beams for suppressing sub-laser light beams of a higher order.

5. An arrangement as claimed in Claim 4, characterized in that the control device (20, 40) controls a rotatably arranged diaphragm disc (35), on which at least two different diaphragms for suppressing sub-laser light beams of a higher order are provided.

6. An arrangement as claimed in any one of the preceding Claims, characterized in that an optical deflection device (21) is provided which comprises an array of mirrors (24, 25, 26) deflecting the sub-laser light beams towards the workpiece (29) at an oblique angle to the plane of the workpiece support.

7. Use of an arrangement as claimed in any one of Claims 1 to 6 for soldering or welding the connecting elements of electronic components (28) by means of laser light onto a printed circuit board (29),
wherein in one production step all the connecting elements of a component (28) are simultaneously soldered or welded,
wherein before the start of a production step for generating a projection pattern, corresponding to the pattern of the soldering or welding positions of the connecting elements, the control device (20) moves the required digital phase grating or a diaphragm, respectively, into the beam path of the laser light beam or the sub-laser light beams, respectively, by rotation of the first and/or second grating discs (12, 13) or the diaphragm disc (14), respectively, and the laser (10) has the laser light beam intensity required for soldering or welding only during a production step.

8. Use of an arrangement as claimed in any one of Claims 1 to 5 for producing foil strips for film capacitors,
wherein in a first production step first lines of evaporated metal are formed on a metal-coated foil (42) and in a second production step the foil (42) is cut along second lines to produce foil strips which are approximately of a width equal to half the width between two first lines, while in each production step the workpiece support (38) moves the foil (42) perpendicularly to the direction of incidence of the sub-laser light beams, wherein before the start of a production step for generating a projection pattern corresponding to the pattern of the evaporation or cutting positions the control device (40) moves the required digital phase gratings or a diaphragm into the beam path of the laser light beam or of the sub-laser light beams by rotation of the first and/or second grating discs (32) or the diaphragm disc (35) and
wherein the laser (30) has the laser light beam intensity required for vapour-deposition or cutting only during a production step.

## Revendications

1. Dispositif pour traiter à la lumière laser une pièce à usiner, comportant un laser (10, 30) dont le faisceau laser est divisé par un diviseur (11, 31) en au moins deux sous-faisceaux laser présentant une intensité sensiblement égale, ainsi qu'un circuit de commande (20, 40) commandant l'intensité lumineuse du laser ainsi que le déplacement mutuel d'un support de pièce à usiner (27, 38) et du laser (10, 30) en vue du positionnement de la pièce à usiner (23, 42), caractérisé en ce que le diviseur (11, 31) comporte au moins un réseau de diffraction de phase binaire (12, 32) divisant le faisceau laser (10, 30) émergeant du laser en une pluralité de sous-faisceaux laser pour former une configuration de projection sur la pièce à usiner (23, 42).

2. Dispositif selon la revendication 1, caractérisé en ce que le circuit de commande (20, 40) commande un premier disque de réseau (12, 32) disposé de façon rotative dans le diviseur (11, 31) et comportant au moins deux réseaux de diffraction de phase binaires.

3. Dispositif selon la revendication 2, caractérisé en ce que le circuit de commande (20, 40) commande un deuxième disque de réseau (13) disposé de façon rotative dans le diviseur (11) et comportant au moins un autre réseau de difa'action de phase binaire pour positionner celui-ci dans le trajet des sous-faisceaux laser.

4. Dispositif selon l'une des revendications précédentes, caractérisé en ce qu'un diaphragme (35) peut être positionné dans le trajet des sous-faisceaux laser pour supprimer des sous-faisceaux laser d'ordre plus élevé.

5. Dispositif selon la revendication 4, caractérisé en ce que le circuit de commande (20, 40) commande un disque à diaphragmes (35) disposé de façon rotative et comportant au moins deux diaphragmes différents pour supprimer des sous-faisceaux laser d'ordre plus élevé.

6. Dispositif selon l'une des revendications précédentes, caractérisé en ce qu'il est prévu un dispositif de déviation optique (21) comportant un système de miroirs (24, 25, 26) faisant dévier les sous-faisceaux laser sur la pièce à usiner sous un angle oblique par rapport au support de pièce à usiner (29).

7. Application d'un dispositif selon les revendications 1 à 6 pour souder ou braser à la lumière laser les éléments de connexion de composants électroniques (28) sur une plaque de circuit imprimé (29) dans laquelle, dans une étape de fabrication, tous les éléments de connexion d'un composant (28) sont fixés simultanément par soudage ou brasage, dans laquelle, avant le commencement d'une étape de fabrication visant la formation d'une configuration de projection correspondant à celle des endroits de soudage, respectivement de brasage, des éléments de connexion, le circuit de commande (2) positionne les réseaux de diffraction de phase binaires nécessaires, respectivement un diaphragme nécessaire, dans le trajet du faisceau laser, respectivement des sous-faisceaux laser, par rotation du premier et/ou du deuxième disque de réseau (12, 13), respectivement du disque à diaphragmes (14), et dans laquelle le laser (10) ne fournit l'intensité de faisceau laser nécessaire pour le soudage ou le brasage que pendant une étape de fabrication

8. Application d'un procédé selon les revendications 1 à 5 pour la fabrication de bandes de feuille destinées pour des condensateurs à feuille, dans laquelle, dans une première étape de fabrication, de premières lignes à métal évaporé sont formées à partir d'une feuille métallisée (42) et dans une deuxième étape de fabrication, la feuille (42) est séparée longitudinalement suivant de deuxièmes lignes pour fabriquer des bandes de feuille présentant une largeur qui est approximativement égale à la mi-largeur entre deux premières lignes du fait que, dans chaque étape de fabrication, le support de pièce à usiner (38) déplace la feuille (42) perpendiculairement à la direction d'incidence des sous-faisceaux laser, dans laquelle, avant le commencement d'une étape de fabrication pour la formation d'une configuration de projection correspondant à celle des endroits d'évaporation, respectivement de découpe, le circuit de commande (40) positionne les réseaux de diffraction de phase binaires nécessaires respectivement un diaphragme nécessaire, dans le trajet du faisceau laser respectivement des sous-faisceaux laser par rotation du premier et/ou du deuxième disque de réseau (32), respectivement du disque à diaphragmes (35), et dans laquelle le laser (30) ne fournit l'intensité de faisceau laser nécessaire pour évaporer ou découper que pendant une étape de fabrication.
